# EUROPEAN PATENT APPLICATION

(11) **EP 2 429 004 A2**
(43) Date of publication of application: **14.03.2012**
(21) Application number: 10191013.1
(22) Date of filing: 12.11.2010
(51) Int. Cl.: H01L 31/18

(54) **Method for manufacturing solar cell**

(30) Priority: 14.09.2010 KR 20100089750
(71) Applicant: Semi-Materials Co., Ltd, Seongnam-si 463-825 (KR)
(72) Inventor: Park, Kun Joo, YongIn-si (KR); Kim, Gi Hong, Daegu-si (KR)
(74) Representative: Neobard, William John

(57) **Abstract**

A method for manufacturing a solar cell includes conducting texturing by injecting plasma on an entire surface of a solar cell wafer, forming an emitter layer by diffusing a solid source on the textured solar cell wafer, forming a passivation layer on the solar cell wafer on which the emitter layer is formed, and forming electrodes. A PSG (PhosphoSilicate Glass) layer is prevented from being formed on the solar cell wafer.

## Description

The present invention relates in general to solar cells and more particularly to a method for manufacturing a solar cell. Embodiments relate to a method for manufacturing a solar cell, in which dry texturing is conducting by injecting plasma, an emitter layer is formed using a solid source, and a passivation layer is formed using a thin oxide layer.

Recently, in consideration of high fuel cost, environmental pollution, exhaustion of fossil fuel energy, disposal of waste matter in atomic power generation, and location selection of a new generator, new and renewable energy has been spotlighted. Among them, research into solar cells, which are a non-polluting energy source, has been actively conducted.

A solar cell is a device which converts light energy into electrical energy using the photovoltaic effect. Solar cell can be classified into silicon solar cells, thin film solar cells, dry-sensitized solar cells, organic polymer solar cells, and the like according to constituent materials thereof. Solar cell may be used as a main power source of an electronic watch, a radio, an unmanned lighthouse, an artificial satellite, a rocket and the like, or an auxiliary power source after being interconnected with a distribution system of a commercial AC power source.

In such a solar cell, it is very important to improve conversion efficiency related to the ratio at which incident sunbeams are converted into electric energy. At the present time, various researches have been conducted to improve the conversion efficiency. Among them, a method is used to maximize the absorption of light by conducting texturing on the wafer surface.

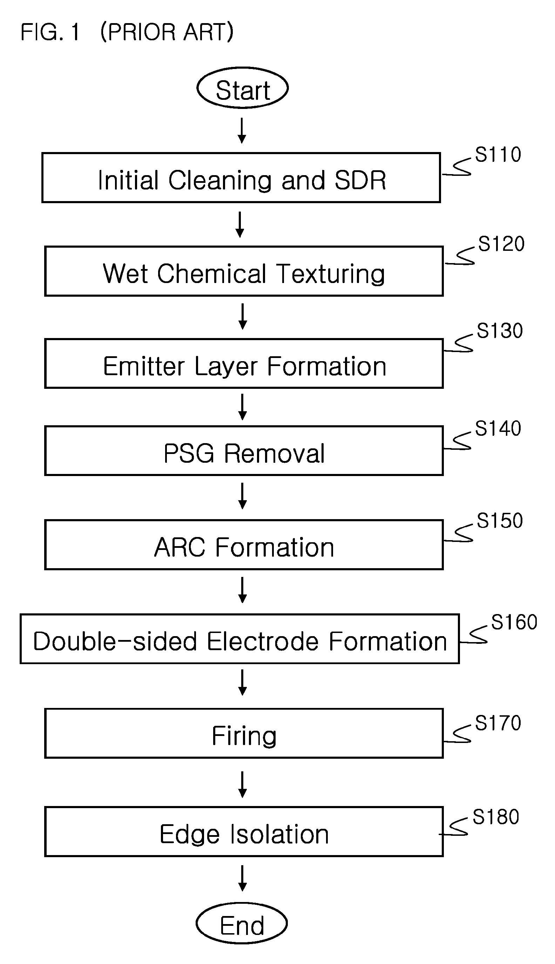

Referring to FIG. 1, a conventional solar cell manufacturing method includes an initial cleaning and SDR (Saw Damage Removal) step (S110), a wet chemical texturing step (S120), a step (S130) of forming an emitter layer on the textured solar cell wafer, a step (S140) of removing a PSG (PhosphoSilicate Glass) layer, a step (S150) of forming an ARC (Anti-Reflection Coating) layer, a step (S160) of forming a double-sided electrode, a firing step (S170), and an edge isolation step (S180).

In the initial cleaning and SDR step (S110), the surface state of the solar cell wafer is improved, that is, damage occurring in the surface of the solar cell wafer when cutting the solar cell wafer using a wire saw is removed. Since the initial cleaning and SDR processes are well known in the art, detailed description thereof will be omitted. It will be apparent to those skilled in the art that various initial cleaning and SDR methods well known in the art can be applied.

In the wet chemical texturing step (S120), the surface of the solar cell wafer is corrugated through wet chemical etching, that is, pyramid shapes with a size of 4 µm to 10 µm are formed on the surface of the solar cell wafer. The reason for conducting the wet chemical texturing is to increase a light absorption amount of available light to the inside of the solar cell by decreasing a light reflection amount.

In the step (S130) of forming the emitter layer on the textured solar cell wafer, when the solar cell wafer is generally P type, phosphorus chloride oxide (POCl₃) or the like are diffused to perform n+ doping. During the diffusion process, oxygen (O₂) forms a diffusion oxide layer referred to as the PSG layer, and the PSG layer grows on the silicon surface.

In the step (S140) of removing the PSG, the undesired PSG layer formed in the step (S130) of forming the emitter layer is removed. This is because the PSG layer absorbs moisture or other impurities and degrades the adhesion property of photoresistor PR.

In the step (S150) of forming the ARC layer, a light reflection amount on the surface of the solar cell is reduced through destructive interference between light reflected from an upper layer and light reflected from a lower layer, and selectivity for a specific wavelength range is increased. This is for increasing the conversion efficiency of the solar cell in consideration of high reflectance on the surface of the solar cell when conducting the wet chemical texturing.

Various materials may be used in order to form the ARC layer. In general, the thickness of the ARC layer can be adjusted using a PECVD method and silicon nitride (Si₃N₄) with high conversion efficiency is deposited. Since this layer is located at the uppermost surface of the wafer, it may also be referred to as a passivation layer.

In the step (S160) of forming the double-sided electrode and the firing step (S170), a front electrode and a rear electrode are printed on the front and rear surfaces of the solar cell wafer and dried, and are subject to a heat treatment process for a contact. In general, the front electrode uses silver (Ag) and the rear electrode uses an aluminum (Al) metal layer. It will be apparent to those skilled in the art that various electrode formation methods well known in the art of the present invention can be applied.

The edge isolation step (S180) is the last step for the electrode isolation. That is, after performing the n+ doping by diffusing the phosphorus chloride oxide (POCl₃) and the like, an unnecessary n+ layer doped on the wafer edge and the like is isolated.

However, the conventional solar cell manufacturing method has the following problems.

In the case where texturing is conducted on the solar cell wafer by wet chemical etching as described above, both surfaces of the solar cell wafer are etched. Generally, while it is required that the solar cell wafer has a thickness of no less than 200 µm, if the texturing through the wet chemical etching is conducted for an ultrathin wafer (a solar cell wafer with a thickness of no greater than 200 µm), breakage of the wafer may be caused as both surfaces of the wafer are etched.

Furthermore, in the case of using the phosphorus chloride oxide (POCl₃) and the like in order to form the emitter layer, since the n+ doping is performed for the entire surface of the solar cell wafer, separate steps of isolating the edge and removing the PSG layer are required, resulting in complication of the manufacturing process.

In addition, since an independent apparatus is used to deposit the silicon nitride (Si₃N₄) used for the ARC layer, the manufacturing cost of the solar cell is inevitably increased.

Accordingly, the present invention has been made in an effort to address problems occurring in the related art.

Embodiments seek to provide a method for manufacturing a solar cell, in which plasma texturing is conducting, an emitter layer is formed using a solid source, and a passivation process is performed in a single equipment, so that the manufacturing process can be simplified and photoelectric conversion efficiency can be improved.

In one aspect, there is provided a method for manufacturing a solar cell, including: conducting texturing by injecting plasma on an entire surface of a solar cell wafer; forming an emitter layer by diffusing a solid source on the textured solar cell wafer; forming a passivation layer on the solar cell wafer on which the emitter layer is formed; and forming electrodes, wherein a PSG (PhosphoSilicate Glass) layer is prevented from being formed on the solar cell wafer.

In the drawings:
FIG. 1 is a flowchart illustrating a conventional solar cell manufacturing method;
FIG. 2 is a flowchart illustrating a method for manufacturing a solar cell embodying the present invention;
FIG. 3A is a sectional view illustrating a method for manufacturing a solar cell in accordance with an embodiment of the present invention, which illustrates a vertical type wafer;
FIG. 3B is a sectional view illustrating a method for manufacturing a solar cell in accordance with an embodiment of the present invention, which illustrates a horizontal type wafer;
FIG. 4 is an enlarged sectional view illustrating a solar cell including a passivation layer made according to a method for manufacturing a solar cell in accordance with an embodiment of the present invention; and
FIGS. 5A and 5B are sectional views illustrating a comparison of a conventional solar cell manufacturing process flow and a solar cell manufacturing process flow in accordance with an embodiment of the present invention.

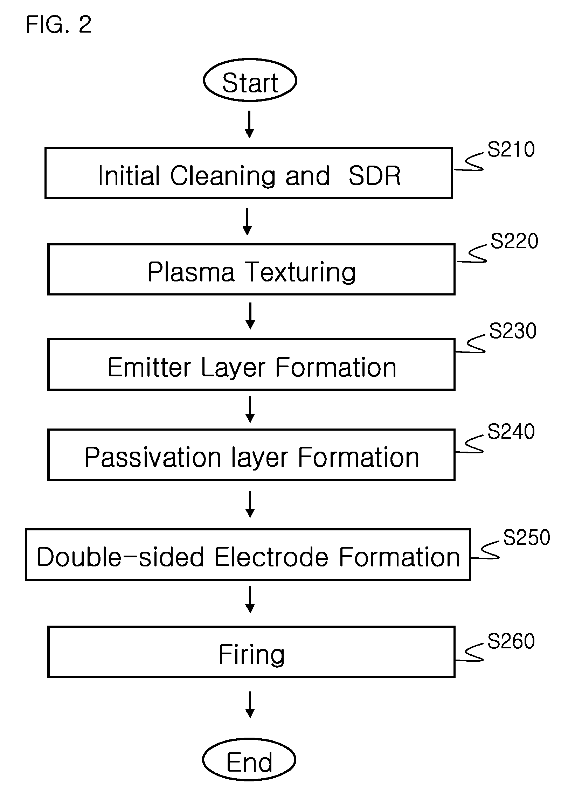

Referring to FIG. 2, a method for manufacturing the solar cell embodying the present invention includes an initial cleaning and SDR step (S210), a step (S220) of conducting texturing by injecting plasma on the entire surface of a solar cell wafer, a step (S230) of forming an emitter layer by diffusing a solid source on the textured solar cell wafer, a step (S240) of forming a passivation layer on the solar cell wafer on which the emitter layer is formed, a step (S250) of forming electrodes on both surfaces of the wafer, and a firing step (S260).

In this method for manufacturing the solar cell, since the initial cleaning and SDR step (S210), step (S250) of forming the electrodes on both surfaces of the wafer, and firing step (S260) are the same as those in the conventional solar cell manufacturing method, detailed description thereof will be omitted in order to avoid redundancy.

In the step (S220) of conducting the texturing by injecting the plasma on the entire surface of the solar cell wafer, the solar cell wafer is processed through plasma ion reaction. If surface texturing is conducted on the solar cell wafer through dry etching, since only one surface of the wafer is etched, the wafer can be prevented from being broken when the surface texturing is applied to an ultrathin wafer (a solar cell wafer with a thickness of no greater than 200 µm). Since dry etching is advantageous in terms of reflectance as compared with wet chemical etching, a process of forming the ARC layer is less important.

The solar cell wafer may use one of a [100] wafer, a [111] wafer, a [110] wafer and a multi-crystalline wafer.

However, in the case of the ultrathin wafer (the solar cell wafer with a thickness of no greater than 200 µm), wafer warpage and the like may occur as the temperature increases through the plasma ion reaction.

In accordance with the embodiment of the present invention, the edge of about 1 mm of the solar cell wafer is compressed and supported using a clamp, so that wafer warpage can be prevented from occurring in the solar cell wafer during the dry etching.

In the step (S230) of forming the emitter layer by diffusing the solid source on the textured solar cell wafer, the emitter layer is formed by diffusing the solid source such that n+ doping is performed for a P type solar cell wafer and p+ doping is performed for an N type solar cell wafer.

In an embodiment, the solid source uses PxOy including phosphorus (P, V group element) in the case of the n+ doping, and BxOy including boron (B, III group element) in the case of the p+ doping.

In the conventional art, since a source such as POCl₃ (n+ doping) or BBr₃ (p+ doping) is used in order to form the emitter layer, an unnecessary PSG layer is formed on the silicon surface, so that a separate process of removing the PSG layer is required.

However, in an embodiment, since a solid source is diffused in order to form the emitter layer, the unnecessary PSG layer is not formed, so that a separate process of removing the PSG layer is not required.

In the step (S240) of forming the passivation layer on the solar cell wafer on which the emitter layer is formed, the passivation layer is formed using an oxide layer to prevent diffusion of moisture on the wafer surface or recombination of carriers.

The passivation layer is formed on a semiconductor element in the final stage as a protective layer, and seals circuit elements thereby to protect them through blocking with the outside. In this embodiment of the present invention, a plasma nitride layer and silicon oxide may be used as the protective layer. Preferably, silicon oxide is used.

As diffusion equipment for forming the emitter layer and the passivation layer, a belt line conveyor system may be used as well as a furnace.

In accordance with the embodiment of the present invention, if the textured solar cell wafer is moved through the belt line, the solid source is placed on the solar cell wafer, the emitted layer is formed as the temperature increases, and then the passivation layer is formed using oxygen. As described above, the passivation layer is formed in-situ by using the belt line conveyor system, so that the manufacturing process can be simplified.

In the step (S250) of forming the double-sided electrode, the rear electrode is printed on the rear surface of the solar cell wafer by using aluminum paste and dried, and the front electrode is printed on the front surface of the solar cell wafer and dried. It will be apparent to those skilled in the art that various electrode formation methods well known in the art of the present invention can be applied.

As described above, in the method for manufacturing the solar cell of the embodiment, since a step of removing the PSG layer is not required, the manufacturing process can be simplified as compared with the conventional art in which the source such as POCl₃ (n+ doping) or BBr₃ (p+ doping) is used. Specifically, since an ARC layer formation process is not required, process time can be reduced. In addition, since an edge isolation process is not required, two or three manufacturing steps can be reduced as compared with the conventional solar cell manufacturing method.

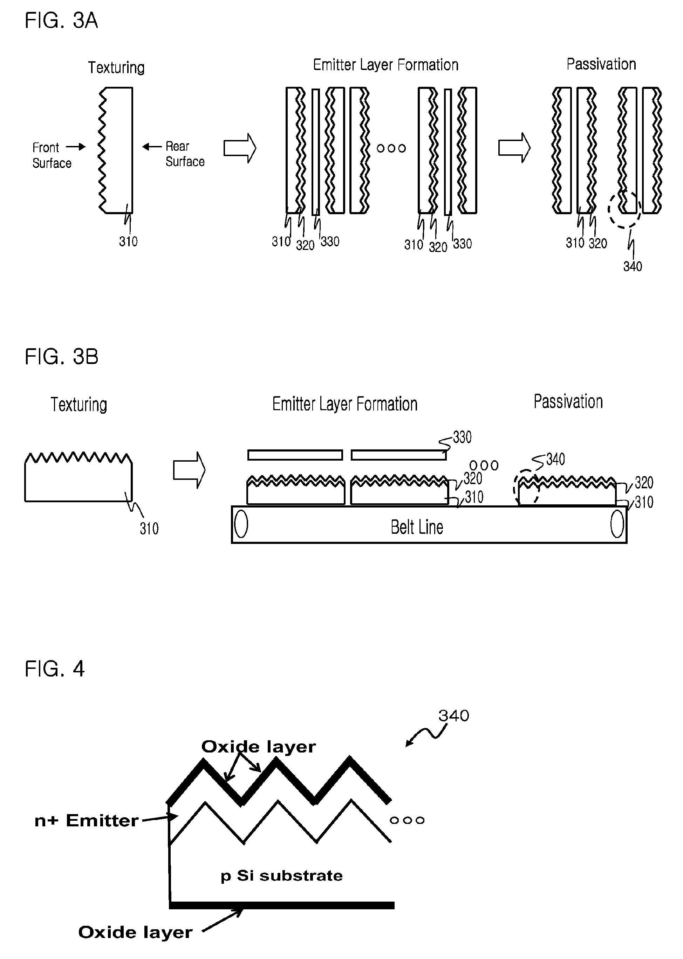

FIGS. 3A and 3B are sectional views illustrating the method for manufacturing the solar cell in accordance with the embodiment of the present invention, wherein FIG. 3A illustrates a vertical type wafer and FIG. 3B illustrates a horizontal type wafer.

The method for manufacturing the solar cell in accordance with the embodiment of the present invention will be described with reference to FIGS. 3A and 3B.

The method for manufacturing the solar cell in accordance with the embodiment of the present invention is characterized in that texturing is conducted on a p type solar cell wafer 310 using dry etching through plasma reaction. V group elements are doped using a solid source 330 to form an n+ type emitter layer 320, and a passivation layer is formed in-situ in a single equipment.

Specifically, in the case of the horizontal type wafer as illustrated in FIG. 3B, the solar cell wafer 310 is moved through the belt line, the solid source 330 is placed on the solar cell wafer 310, and the emitter layer 320 is formed by increasing the temperature. Then, the passivation layer is formed using oxygen.

FIG. 4 is an enlarged sectional view illustrating a solar cell including the passivation layer according to the method for manufacturing the solar cell in accordance with the embodiment of the present invention.

As illustrated in FIG. 4, the solar cell in accordance with the embodiment of the present invention is characterized in that the n+ emitter layer is formed on the entire surface of the texture p type wafer, and then the oxide passivation layer is formed on the emitter layer and the rear surface of the p type wafer.

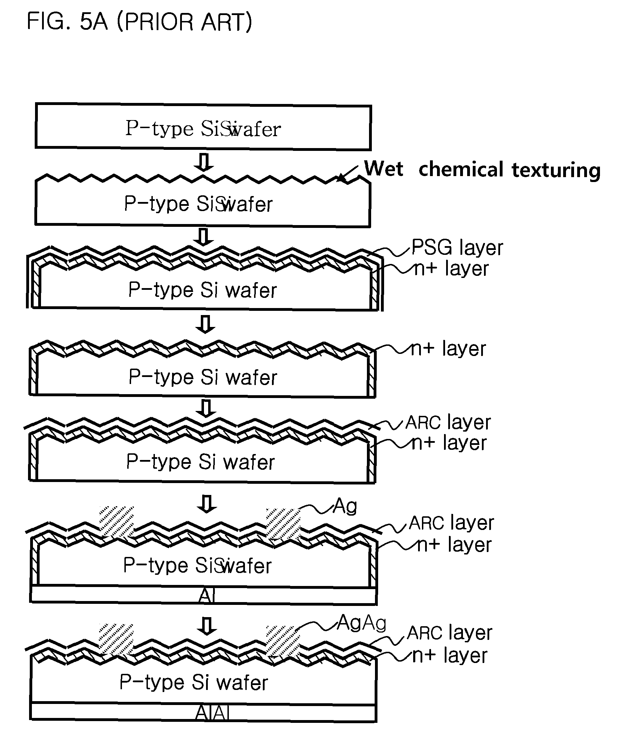

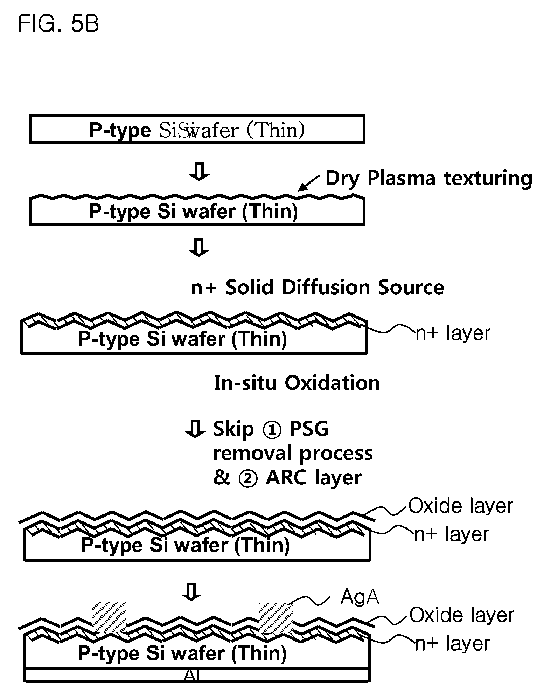

FIGS. 5A and 5B are sectional views illustrating a comparison of the conventional solar cell manufacturing process flow and the solar cell manufacturing process flow in accordance with the embodiment of the present invention.

As illustrated in FIGS. 5A, in the conventional solar cell manufacturing method, a p type wafer is used because wet texturing facilitates etching in the form of a pyramid according to crystalline direction of silicon. Next, phosphorous (P) doping is performed in order to form an emitter layer. At this time, during the diffusion process, an unexpected PSG oxide layer is formed. Then, a process of removing the unexpected PSG oxide layer is performed, and an ARC layer and electrodes are formed.

However, As illustrated in FIGS. 5B, the solar cell manufacturing method in accordance with the embodiment of the present invention is characterized in that dry texturing is conducted regardless of the type of a wafer. An emitter layer is formed using a solid source and an oxide passivation layer is formed in-situ through a belt line conveyor system, resulting in the simplification of the manufacturing process. Since the conventional high temperature diffusion scheme is not used in order to form the emitter layer, the last edge isolation process of isolating an edge is not required.

In accordance with the embodiment of the present invention, the manufacturing process is simplified while maintaining the high photoelectric conversion efficiency of a solar cell, so that the manufacturing cost can be reduced.

Although a preferred embodiment of the present invention has been described for illustrative purposes, those skilled in the art will appreciate that various modifications, additions and substitutions are possible, without departing from the scope of the invention as recited in the accompanying claims.

## Claims

1. A method for manufacturing a solar cell, comprising the steps of:
texturing by injecting plasma on an entire surface of a solar cell wafer;
forming an emitter layer by diffusing a solid source on the textured solar cell wafer;
forming a passivation layer on the solar cell wafer on which the emitter layer is formed; and
forming electrodes,
wherein no PSG (PhosphoSilicate Glass) layer is formed on the solar cell wafer.

2. The method according to claim 1, wherein the forming of the emitter layer and the forming of the passivation layer are performed in-situ in a single apparatus.

3. The method according to claim 2, wherein the single apparatus is a belt line conveyor, and a rear surface of the textured solar cell wafer is placed on the belt line conveyor.

4. The method according to claim 1 or 2, wherein, in the conducting of the texturing, the solar cell wafer is one of a [100] wafer, a [111] wafer, a [110] wafer and a multi-crystalline wafer.

5. The method according to claim 1,2 or 3 wherein, in the conducting of the texturing, a depth of the texturing is approximately 1 µm to approximately 4 µm.

6. The method according to any preceding claim, wherein the forming of the emitter layer is performed in a temperature range of approximately 700°C to approximately 1000°C.

7. The method according to any preceding claim, wherein, in the forming of the emitter layer, the solid source is PxOy including phosphorus (P) or BxOy including boron (B).
